# FASCICULE DE BREVET EUROPEEN

(11) **EP 3 000 136 B1**
(45) Date de publication et mention de la délivrance du brevet: **10.04.2019**
(21) Numéro de dépôt: 14729408.6
(22) Date de dépôt: 12.05.2014
(51) Int. Cl.: H01L 31/054, H01L 31/0352, H01L 31/05, H01L 31/075

(54) **PROCÉDÉ DE FABRICATION D'UN SYSTÈME PHOTOVOLTAÏQUE À CONCENTRATION DE LUMIÈRE**
VERFAHREN ZUR HERSTELLUNG EINES FOTOVOLTAISCHEN LICHTKONZENTRATIONSSYSTEMS
METHOD FOR PRODUCING A LIGHT CONCENTRATING PHOTOVOLTAIC SYSTEM

(30) Priorité: 22.05.2013 FR 1354616
(43) Date de publication de la demande: 30.03.2016
(73) Titulaire: Electricité de France, 75008 Paris (FR); Centre National de la Recherche Scientifique - CNRS, 75794 Paris Cedex 16 (FR)
(72) Inventeur: PAIRE, Myriam, 75017 Paris (FR); GUILLEMOLES, Jean-François, 75013 Paris (FR); LOMBEZ, Laurent, 92000 Nanterre (FR); LINCOT, Daniel, 92160 Antony (FR); COLLIN, Stéphane, 94230 Cachan (FR); PELOUARD, Jean-Luc, 75020 Paris (FR)
(74) Mandataire: Cabinet Plasseraud
(86) Numéro de dépôt international: PCT/FR2014/051092
(87) Numéro de publication internationale: WO 2014/188104

(56) Documents cités:
- WO-A1-2011/072708
- WO-A2-2008/071180
- FR-A1- 2 961 022
- US-A1- 2011 247 682

## Description

### DOMAINE TECHNIQUE

L'invention se rapporte au domaine des systèmes photovoltaïques équipés de concentrateurs de lumière.

### ARRIÈRE-PLAN TECHNOLOGIQUE

Les systèmes photovoltaïques à concentration de la lumière, dans lesquels un système optique permet d'augmenter l'intensité lumineuse reçue par des cellules solaires, sont utilisés pour augmenter les rendements de conversion des cellules photovoltaïques. Cette technologie utilise avantageusement des cellules de petite taille à haut rendement, coûteuses, comme les cellules monocristallines en semi-conducteur III-V. Cette technologie permet en outre de réduire la quantité de matière utilisée pour fabriquer les cellules.

Cependant, les zones entre les cellules ne comprennent pas de matériau photosensible et ne participent donc pas à la génération de courant électrique. Si de la lumière arrive dans ces zones, elle est perdue. Par conséquent, les modules à concentration ne fonctionnent bien que lorsque l'illumination du Soleil est directe. Par temps nuageux, lorsque la lumière est diffuse ou si le système n'est pas bien aligné par rapport à la source lumineuse, le rendement de ces systèmes chute considérablement.

Afin d'exploiter l'espace inutilisé entre cellules à concentration, certains documents, comme par exemple WO-11/156344, US-13/399 711 proposent d'allier des systèmes émetteurs de lumière avec des cellules photovoltaïques. Cette optimisation de l'espace entre cellules ne permet pourtant pas de compenser les baisses de rendement des systèmes à concentration dès que ces derniers s'éloignent des conditions de fonctionnement idéales. Le document WO 2011/072708 A1 propose d'exploiter l'espace entre cellules à concentration avec un deuxième réseau de cellules solaires pour capter l'illumination diffuse.

Il existe par conséquent un besoin de mettre au point des systèmes photovoltaïques aptes à fonctionner aussi bien dans des conditions d'éclairement idéales que dans des conditions d'éclairement non optimales, par exemple par temps nuageux, ou en l'absence de système de suivi de la source lumineuse. Par ailleurs, il est avantageux de prévoir des systèmes photovoltaïques à concentration de préférence peu onéreux et simples à réaliser.

### EXPOSE DE L'INVENTION

Pour y parvenir la présente invention propose un procédé de fabrication selon la revendication 1 d'un système photovoltaïque à concentration de la lumière exploitant les composantes directes et diffuses de l'illumination grâce à un empilement de couches structuré en deux réseaux de cellules photovoltaïques intercalées. Le système photovoltaïque obtenu à l'aide de ce procédé fait également partie de l'invention.

L'invention se rapporte donc à un procédé de fabrication d'un dispositif photovoltaïque à concentration de lumière, comprenant :
- une première étape de fabrication, sur un substrat, d'un premier réseau de cellules photovoltaïques à partir d'un empilement de couches déposé sur le substrat, les cellules du premier réseau étant reliées à un premier groupe de connecteurs électriques,
- une deuxième étape de formation d'un système de concentration de lumière au-dessus des cellules du premier réseau.

Le procédé comprend en outre :
- une troisième étape, préalable à la deuxième étape au moins, de formation, sur le substrat, d'un second réseau de cellules photovoltaïques à partir d'un empilement de couches déposé sur le substrat, les cellules du second réseau étant intercalées avec les cellules du premier réseau et reliées à un second groupe de connecteurs électriques et étant dépourvues de système de concentration de lumière où les empilements respectifs de la première étape et de la troisième étape comportent au moins une couche commune.

Le terme « réseau » concerne a minima un ensemble de deux cellules photovoltaïques. De cette manière, la plus petite structure réalisée par ce procédé comprend deux cellules sous une optique de concentration formant le premier réseau et deux cellules formant le second réseau.

Ce procédé présente l'avantage d'utiliser des techniques peu coûteuses pour réaliser les cellules photovoltaïques des premier et second réseaux. Les techniques de fabrication de couches minces pour former à la fois les cellules classiques et les cellules à concentration permettent de grandement simplifier le procédé de fabrication de cet ensemble de cellules. La réalisation de cellules à partir d'un empilement de couches minces présente donc des avantages en termes de gains en coûts, temps et simplicité de fabrication. Ceci rend le procédé plus adapté à une mise en oeuvre à une échelle industrielle.D'autre part, l'utilisation sur un même panneau, d'un empilement de couches à la fois pour une cellule à concentration et pour une cellule classique entourant ladite cellule à concentration est un concept contre-intuitif pour un Homme de l'art. En effet, il est généralement admis qu'un type particulier d'empilement de couches est nécessaire pour fabriquer chacun des deux types de cellules. Il est généralement admis qu'un premier type de cellule de fort rendement doit être utilisé pour l'utilisation sous concentration, alors qu'un deuxième type, à plus faible rendement mais moindre coût recouvre les zones sans concentration. L'utilisation éventuelle de cellules en couches minces à concentration n'est envisagée que dans l'optique d'une réduction de la matière rare utilisée pour réaliser des structures photovoltaïques, et donc la limitation de la surface couverte par ces cellules est primordiale dans cette approche de réduction des matières premières. L'utilisation de couches minces pour fabriquer des cellules « classiques » sans concentration avec un empilement de couches sur un panneau destiné à accueillir des cellules à concentration elle-même en couches minces paraît donc contre-intuitive, voire inenvisageable. Les cellules en couches minces bon marché utilisées dans les systèmes de cellules conventionnelles sans concentration sont quant à elles considérées comme ayant un rendement trop faible pour être utilisées dans un système avec concentration de la lumière.

Par conséquent un empilement de couches réalisé sur un même substrat combinant des cellules à concentration intercalées avec des cellules «classiques » sans concentration serait a priori considéré comme un système inefficace pour au moins l'une des deux catégories de cellules. L'invention propose ainsi un agencement de cellules regroupées sur un même substrat à partir d'un empilement de couches, simplifiant grandement le procédé de fabrication d'un panneau et diminuant son coût de fabrication. L'effet peut être encore plus marqué lorsque les cellules à concentration et les cellules sans concentration avec lesquelles elles sont intercalées sont toutes les deux réalisées à partir d'un empilement de couches utilisant les mêmes matériaux, avantageusement un même empilement de couches.

De plus lorsque la formation de chacun des réseaux est de même type et présente sensiblement les mêmes propriétés, le procédé présente l'avantage supplémentaire d'agencer directement les deux réseaux de cellules, via la seule étape de formation de contacts électriques. Par rapport à un panneau en couches minces classique sans concentration, le procédé permet d'obtenir de meilleurs rendements, en utilisant la lumière concentrée issue d'une optique de concentration dédiée, sur une zone adaptée. En particulier les cellules du premier réseau se caractérisent par au moins une dimension latérale petite : les contacts électriques spatialement rapprochés permettent de minimiser les pertes résistives même lorsque les densités de courant deviennent élevées, ce qui est le cas sous concentration, et la petite taille des cellules permet de minimiser l'élévation de température consécutive à l'élévation du flux lumineux incident.

Ainsi lorsque la lumière incidente est principalement diffuse, l'ensemble de la zone photovoltaïque est illuminée de manière homogène. Les cellules des premier et second réseaux sont soumises au même flux lumineux, et le panneau fonctionne comme un panneau en couches minces sans concentration. Dès que la lumière incidente contient une portion de lumière directe, et que l'optique de concentration est orientée correctement, les cellules du premier réseau de la zone photovoltaïque sont éclairées par un flux lumineux concentré, et ainsi leur rendement augmente. Il y a donc un gain de rendement.

Le procédé présente l'avantage de permettre une optimisation dans le choix des paramètres propres aux cellules de chacun des deux réseaux : que ce soit dans le choix de leurs tailles respectives, de leurs formes, de leur agencement les uns par rapport aux autres, ou de la manière dont elles sont connectées entre elles.

Par ailleurs, les cellules des deux réseaux possèdent au moins une couche commune, ce qui permet de fait de considérer le dispositif photovoltaïque ainsi fabriqué comme étant une seule cellule photovoltaïque structurée en des zones destinées à collecter la lumière concentrée arrivant en incidence directe et des zones destinées à recevoir la lumière diffuse.

Par couche commune, il s'entend toute couche qui serait déposée simultanément sur l'ensemble des deux réseaux. Cette couche commune peut présenter des évidements réalisés postérieurement au dépôt, où des structures liées au masquage de certaines zones, de l'un ou l'autre des réseaux, pour les protéger du dépôt. Une couche commune peut donc présenter des évidements ou être discontinue.

Les empilements respectifs de la première étape et de la troisième étape du procédé peuvent être identiques. De cette manière, les matériaux constitutifs des couches minces des cellules du premier et du second réseaux sont les mêmes. Cependant, de légères discontinuités liées à des défauts de fabrication ou à des différences de dopage peuvent apparaître localement. L'utilisation du même empilement de couches pour les cellules des deux réseaux simplifie grandement le procédé de fabrication, notamment en rendant sa mise en oeuvre plus rapide. Par ailleurs, la fabrication des cellules s'effectuant en une seule étape de croissance, il est possible de réaliser des cellules de composition plus homogène.

Les cellules à concentration font référence à des cellules aptes à supporter des contraintes thermiques pouvant être importantes lorsque la lumière issue du Soleil est concentrée avec des systèmes optiques de concentration comprise, par exemple, entre 5 et 1000. Les cellules à concentration ont avantageusement une dimension caractéristique, par exemple une largeur, pouvant être comprise entre 10 µm et 2 mm, tandis que les cellules du second réseau ont une dimension caractéristique, par exemple une largeur, de sensiblement 1 cm.

Il se peut également que les cellules du premier réseau soient agencées dans des évidements réalisés dans au moins une partie des matériaux formant les cellules du second réseau.

Cette manière d'agencer les étapes du procédé simplifie le procédé en permettant de fabriquer d'un bloc toutes les cellules photovoltaïques du second réseau de cellules. Des évidements sont ensuite réalisés, par exemple par gravure, pour libérer, sélectivement, en ayant le choix de leur taille et de leur forme, des zones destinées à accueillir les cellules à concentration du premier réseau.

Différents procédés de réalisation utilisant cet agencement des cellules à concentration dans des évidements réalisés dans au moins une partie des matériaux formant les cellules du second réseau sont envisagés.

Par exemple, un procédé de fabrication du système photovoltaïque peut avantageusement comprendre les étapes successives suivantes :
- la formation, sur un substrat, d'un empilement de couches minces,
- la gravure, dans l'empilement de couches minces, d'évidements définissant le premier et le second réseau de cellules photovoltaïques,
- le dépôt, dans ces évidements, d'un matériau électriquement isolant,
- le dépôt, sur une partie du matériau électriquement isolant adjacente aux cellules du premier réseau, des contacts métalliques du premier réseau de cellules photovoltaïques.

Ce procédé présente l'avantage de ne pas avoir recours à des matériaux différents pour fabriquer les cellules à concentration et les cellules du second réseau. Les cellules à concentration peuvent alors être des cellules de type couches minces, peu coûteuses. Grâce à ce procédé, ces cellules peuvent être fabriquées en même temps que les cellules du second réseau fonctionnant sans concentration de la lumière. Leur rendement est moindre, compris entre 15% et 20%, que celui des meilleures cellules à concentration, atteignant typiquement des rendements compris sensiblement entre 30% et 40%. Par contre, le procédé étant rapide et simple à mettre en oeuvre, il permet de réaliser à moindre coût des systèmes photovoltaïques adaptés aux régions à ensoleillement plus faible que dans les zones à fort ensoleillement constituant la « sun belt », selon la terminologie anglo-saxonne. En effet dans les zones où l'ensoleillement direct est présent mais pas aussi intense que dans la sun-belt, le niveau de concentration que peut atteindre un système n'est pas suffisant pour justifier économiquement l'utilisation de cellules III-V extrêmement coûteuses, même si la zone entre ces cellules est utilisée pour de la génération d'électricité. Par contre ce type de climat convient parfaitement au système proposé dans cette invention, qui profite du gain de rendement offert par la lumière directe, sans nécessiter un surcoût important. Le système peut s'accommoder, suivant ses variantes, de concentrations typiquement comprises entre 2 et 500.

Alternativement, il est proposé un procédé comprenant les étapes successives suivantes :
- la formation, sur un substrat, d'un empilement de couches minces,
- la gravure, dans l'empilement de couches minces, d'évidements délimitant le second réseau de cellules photovoltaïques,
- le dépôt, dans une partie des évidements créés, de cellules à concentration formant le premier réseau de cellules photovoltaïques.

Ce procédé alternatif permet de choisir des matériaux différents pour les cellules photovoltaïques à concentration et les cellules photovoltaïques du second réseau. La gravure d'évidements dans au moins une partie des matériaux constituant les cellules photovoltaïques du second réseau permet de choisir la taille et la forme des cellules à concentration. Ce procédé autorise en plus de placer, dans ces évidements, des cellules différentes, potentiellement plus performantes que celles du second réseau, comme par exemple des cellules à base de semi-conducteurs III-V. Il autorise également le choix de matériaux à spectres d'absorption différents pour les cellules du second réseau et les cellules à concentration, afin d'optimiser le système photovoltaïque aux conditions d'illumination sous lumière directe et diffuse.

Un procédé sensiblement différent peut comprendre les étapes successives suivantes :
- le dépôt, sur le substrat, d'une couche métallique formant contact arrière,
- la gravure, dans cette couche métallique, d'évidements délimitant les contacts arrière du premier et du second réseau de cellules photovoltaïques,
- le dépôt, sur ces contacts arrière, des cellules photovoltaïques du premier et du second réseau.

Ce procédé représente une alternative avantageuse aux procédés qui différencient les cellules des deux réseaux par leurs contacts électriques supérieurs. En effet, des contacts arrière différenciés pour les cellules du premier réseau et les cellules du second réseau offrent la possibilité de déposer un contact électrique supérieur commun aux cellules des deux réseaux.

Notamment, ce procédé peut comprendre les étapes successives suivantes :
- le dépôt, sur le substrat, d'un masque délimitant deux réseaux de zones exposées intercalées,
- le dépôt, sur ce substrat, d'un métal formant deux réseaux de contacts arrière intercalés,
- le dépôt, sur ces contacts arrière, des cellules photovoltaïques du premier et du second réseau.

En différenciant ainsi les contacts électriques des cellules du premier réseau de ceux des cellules du second réseau, il devient possible de déposer sélectivement des matériaux différents sur les contacts arrière des cellules de chacun des deux réseaux. Ceci permet notamment de choisir des matériaux photosensibles aux propriétés d'absorption différentes pour les absorbeurs des cellules à concentration et les cellules du second réseau. De cette manière, les cellules à concentration peuvent comprendre un absorbeur adapté aux longueurs d'onde contenues majoritairement dans le rayonnement perçu en illumination directe, avec peu de filtrage et de diffusion. Concomitamment, les cellules du second réseau peuvent comprendre un absorbeur adapté aux longueurs d'onde contenues majoritairement dans le rayonnement perçu en illumination diffuse. Les deux réseaux de cellules peuvent alors avoir en commun la même couche tampon et le même contact avant. Il est également possible d'avoir un même absorbeur commun aux cellules des deux réseaux. Avantageusement cet absorbeur commun ainsi qu'éventuellement d'autres couches à l'exception des contacts arrière, forment des couches continues s'étendant sur tout le panneau photovoltaïque.

Le dépôt des cellules peut avantageusement se faire par des technologies de croissance bottom-up, par exemple via des étapes d'électro-dépôt. Par ailleurs, il est possible de déposer un matériau électriquement isolant entre les contacts arrière, avant la réalisation des cellules photovoltaïques à proprement dites et ensuite déposer un empilement de couches commun aux cellules des deux réseaux. La présence d'une largeur comprise entre 3 µm et 20 µm de matériau électriquement isolant permet d'empêcher les porteurs, électrons ou trous, de transiter d'une cellule photovoltaïque à l'autre, étant donné que la longueur de diffusion typique d'un porteur dans l'absorbeur d'une cellule photovoltaïque est inférieure à 3 µm, typiquement comprise entre 500 nm et 1 µm. La présence de ce matériau isolant permet à la résistance de fuite induite par la présence d'une couche d'absorbeur d'être élevée, c'est-à-dire, par exemple, supérieure à 500 Ωcm².

L'invention se rapporte également à un système photovoltaïque à concentration de la lumière, issu du procédé décrit ci-avant.

Ce système photovoltaïque à concentration de lumière comprend :
- un premier réseau de cellules photovoltaïques en empilement de couches déposé sur le substrat, les cellules du premier réseau étant reliées à un premier groupe de connecteurs électriques, et
- un système de concentration de la lumière, ce système étant agencé au-dessus des cellules du premier réseau.

Ce système photovoltaïque comprend en outre:
- un second réseau de cellules photovoltaïques en empilement de couches déposé sur le substrat, les cellules du second réseau étant intercalées avec les cellules du premier réseau et reliées à un second groupe de connecteurs électriques, et étant dépourvues de système de concentration de lumière où les empilements des premier et second réseaux comportent au moins une couche commune.

Un tel agencement de cellules photovoltaïques dites « classiques », intercalées avec des cellules à concentration, permet d'optimiser la quantité de lumière reçue par un panneau de cellules photovoltaïques par exemple en couches minces équipé d'un système optique de concentration de la lumière.

Lorsque les conditions d'illumination sont bonnes, avec de la lumière directe arrivant sous incidence normale sur le système optique, les cellules du premier réseau, optimisées pour la lumière concentrée, captent l'essentiel de l'énergie lumineuse, ce qui permet d'augmenter leur rendement pour générer plus d'électricité.

Dès que les conditions d'illumination s'éloignent de cet optimum, le système photovoltaïque décrit ci-avant demeure efficace dans la mesure où l'énergie lumineuse est répartie de manière homogène sur la zone photovoltaïque, et on obtient donc sensiblement les mêmes rendements qu'un panneau en couches minces classique. Ce dispositif est donc particulièrement adapté pour des applications dans des zones à ensoleillement direct plus faible que dans la « sun belt », dans lesquelles des systèmes à concentration classiques sont peu rentables.

Les empilements des premier et second réseaux comportent au moins une couche commune. Ceci permet de considérer le système photovoltaïque comme ne faisant intervenir qu'une seule cellule subdivisée en zones à concentration d'une part et en zones sans concentration d'autre part grâce au positionnement des contacts électriques.

Selon un mode de réalisation particulièrement avantageux, les empilements de couches sont identiques pour les deux réseaux de cellules. Ceci permet notamment de bénéficier de structures en couches minces plus homogènes, avec moins de défauts et de disparités entre cellules.

Le rapport entre les aires des surfaces supérieures des cellules dites « classiques » pour un flux non concentré et des cellules à concentration pour flux concentré peut varier, notamment en fonction des zones géographiques dans lesquelles le dispositif est utilisé. Le rapport des aires est directement lié au niveau de concentration visé qui peut varier dans notre invention typiquement entre 2 et 500. De plus, il est avantageux de privilégier des cellules à concentration plus larges dans les zones moins ensoleillées et plus nuageuses, où les niveaux de concentration seront faibles , par exemple atteignant une valeur de quatre, avec des cellules longilignes à concentration d'une largeur de 250 µm associées à des cellules « classiques » longilignes de 1 cm de large. Alternativement, les cellules à concentration peuvent avoir une largeur de 100 µm alors que les cellules classiques ont une largeur de sensiblement 1 cm dans les zones plus ensoleillées et moins nuageuses, où la focalisation de la lumière sur les cellules à concentration est plus efficace, atteignant un facteur 100.

Afin de séparer les contacts électriques des cellules à concentration de ceux des cellules « classiques », il est avantageux d'utiliser un matériau électriquement isolant. Lorsque les cellules photovoltaïques du premier réseau sont espacées des cellules photovoltaïques du second réseau par un matériau électriquement isolant, la réalisation de contacts électriques séparés pour les deux réseaux de cellules en est simplifiée.

De manière particulièrement avantageuse, le matériau électriquement isolant sépare les cellules du premier réseau des cellules du second réseau d'une distance comprise entre 10 µm et 100 µm, avantageusement 20 µm. Cette distance permet de bloquer de manière effective le transfert des porteurs d'une cellule photovoltaïque vers une cellule voisine, même lorsque les deux cellules partagent le même absorbeur. En effet, la longueur de diffusion moyenne des porteurs dans un absorbeur de cellule photovoltaïque est inférieure à 3 µm. Avec un matériau isolant séparant les contacts électriques avant ou contacts électriques supérieurs en ZnO des couches supérieures des cellules de plus de 5 µm, les porteurs ont une probabilité très faible de passer d'une cellule à l'autre.

Par conséquent, les surfaces situées sous le matériau électriquement isolant ne participent pas à la génération d'électricité. La surface supérieure du matériau isolant correspond alors à une surface particulièrement adaptée pour recevoir les contacts métalliques en surface. En effet, les contacts métalliques, réfléchissant la lumière du spectre solaire, bloqueraient autrement le rayonnement incident arrivant sur les cellules photosensibles.

Il est possible d'adapter la composition des matériaux formant les cellules à concentration et les cellules « classiques » du second réseau. Par exemple, les cellules photovoltaïques du premier réseau peuvent comprendre une couche à propriétés photovoltaïques réalisée dans un matériau différent d'une couche à propriétés photovoltaïques que comportent les cellules photovoltaïques du second réseau. Par exemple, il est possible d'utiliser des contacts arrière différenciés pour appliquer des tensions différentes aux zones définissant les cellules des premier et second réseaux. Avec un procédé de dépôt électrolytique des couches minces, il est alors possible d'obtenir des zones de compostions différentes pour les deux réseaux de cellules.

Cette différence dans les matériaux constituant les absorbeurs des cellules du premier et du second réseau présente l'avantage d'autoriser un calibrage des spectres d'absorption des deux réseaux de cellules. Notamment, il est possible de choisir des matériaux à plus forte absorption dans l'UV et le visible pour les cellules à concentration, fonctionnant de manière optimale dans des conditions de forte illumination en lumière directe.

De manière à améliorer le fonctionnement des cellules à concentration, il est possible de prévoir un dispositif de suivi de la source du rayonnement incident, associé au système photovoltaïque décrit ci-avant. Un tel dispositif, communément appelé dispositif de « tracking » selon la terminologie anglo-saxonne, permet d'aligner le système photovoltaïque de concentration en direction du Soleil, de manière à ce que l'essentiel des rayons lumineux arrive sous illumination directe sur les cellules à concentration. Les cellules à concentration, lorsqu'elles fonctionnent sous flux concentré, présentent un gain de rendement, typiquement de 2 points de rendement par décade de concentration, et ont donc un rendement amélioré par rapport aux cellules fonctionnant sous flux non concentré. Ce gain de rendement apparaît grâce à l'optimisation des cellules à concentration, adaptées pour les flux lumineux intenses, par la diminution d'une dimension caractéristique, comme la largeur, de façon suffisante pour résister aux contraintes thermiques et résistives.

### DESCRIPTIF DES FIGURES

D'autres avantages et caractéristiques de l'invention apparaîtront à la lecture de la description détaillée ci-après d'exemples de réalisation présentés à titre illustratif, aucunement limitatifs, et en référence aux dessins annexés sur lesquels :
- la figure 1 illustre un exemple de dispositif photovoltaïque à concentration pouvant être issu du procédé objet de l'invention;
- la figure 2 illustre les trois principales étapes du procédé de fabrication d'un système photovoltaïque à concentration objet de l'invention;
- les figures 3a à 3f illustrent six étapes d'un procédé de fabrication d'un système photovoltaïque à concentration, selon un premier mode de réalisation;
- les figures 4a à 4e illustrent cinq étapes d'un procédé de fabrication d'un système photovoltaïque à concentration, selon un second mode de réalisation;
- les figures 5a à 5c illustrent trois étapes d'un procédé de fabrication d'un système photovoltaïque à concentration, selon un troisième mode de réalisation;
- la figure 6 illustre les étapes d'un procédé de fabrication d'un système photovoltaïque à concentration, selon un quatrième mode de réalisation.

Pour des raisons de clarté, les dimensions des différents éléments représentés sur ces figures ne sont pas nécessairement en proportion avec leurs dimensions réelles. Sur les figures, des références identiques correspondent à des éléments identiques.

### DESCRIPTION DÉTAILLÉE

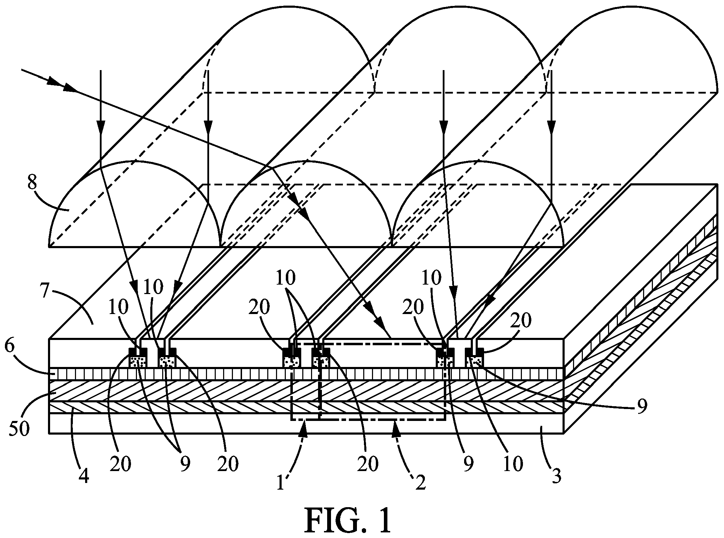

Comme illustré sur la figure 1, l'objet de la présente invention concerne principalement la fabrication de systèmes photovoltaïques à concentration de lumière. Le système photovoltaïque à concentration de lumière comprend notamment au moins un empilement de couches structuré en deux réseaux intercalés de cellules photovoltaïques. Cet empilement de couches comprend d'une part des zones formant un premier réseau de cellules photovoltaïques comprenant des cellules photovoltaïques à concentration 1, au-dessus desquelles se trouvent des systèmes optiques de focalisation de la lumière, comme par exemple des lentilles 8. Les cellules de ce premier réseau comprennent en surface des contacts métalliques 10, permettant en outre de relier en série les cellules à concentration 1. Les cellules du premier réseau peuvent être reliées entre elles en série, en parallèle ou bien combiner des liaisons en parallèle avec des liaisons en série. Entre les cellules du premier réseau, l'empilement de couches comprend des zones formant des cellules photovoltaïques plus larges 2, appartenant à un second réseau. Elles peuvent comprendre des contacts métalliques 20 en surface indépendants des contacts métalliques 10 des cellules du premier réseau. Ces cellules sont avantageusement reliées entre elles en série. Tout comme pour les cellules du premier réseau, d'autres modes de connexion sont possibles, en parallèle ou bien en combinant des liaisons en série et en parallèle. Les cellules des premier et second réseaux sont séparées électriquement par exemple par un matériau isolant 9 ou encore par gravure de l'ensemble jusqu'au substrat.

Ce système photovoltaïque à concentration permet de recouvrir une grande surface de panneau photovoltaïque, destiné à fonctionner en concentration, avec des cellules photosensibles à partir d'au moins un empilement de couches. De cette manière ce système permet d'exploiter à la fois les composantes directes de l'illumination, par focalisation de la lumière sur les cellules photovoltaïques à concentration 1 du premier réseau, et les composantes diffuses de l'illumination, grâce aux absorbeurs des cellules photovoltaïques 2 du second réseau.

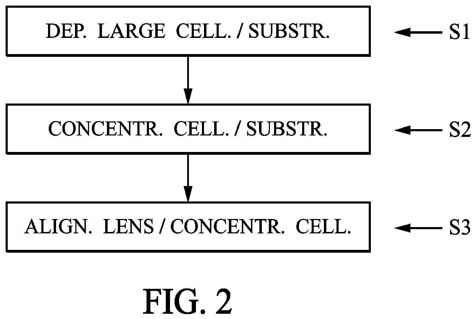

De manière avantageuse, le dispositif représenté à la figure 1 est réalisé en trois grandes étapes, tel qu'illustré schématiquement sur la figure 2.

Une première étape S1 consiste à fabriquer, sur un substrat 3, les larges cellules photovoltaïques 2 destinées à former les cellules du second réseau. Ces cellules photovoltaïques 2 peuvent avantageusement être des cellules en couches minces, peu coûteuses à produire.

Les cellules photovoltaïques 2 du second réseau peuvent être fabriquées par croissance bottom-up à partir d'un substrat 3. Cette technique s'applique particulièrement aux cellules en couches minces. Il est ainsi possible de fabriquer ces cellules photovoltaïques 2 en prévoyant le masquage de zones destinées à accueillir ultérieurement les cellules photovoltaïques 1 du premier réseau. Il est également possible de faire croître les couches de matériaux communes aux cellules photovoltaïques 1, 2 des deux réseaux, avant de différencier les cellules du premier et du second réseau par le dépôt d'isolants électriques 9. Ces couches communes peuvent typiquement comprendre : le contact arrière métallique 4, l'absorbeur 50, et la couche tampon 6.

De manière particulièrement avantageuse, l'étape 1 comprend la réalisation, sur une large surface de substrat 3, d'un empilement de couches minces. Des emplacements destinés à accueillir les cellules à concentration 1 peuvent être gravés dans cet empilement de couches minces, délimitant par la même occasion les cellules photovoltaïques 2 du second réseau de cellules. La gravure réalisée peut avantageusement s'arrêter à la couche arrière 4, qui est généralement une couche métallique électriquement conductrice en molybdène. Cette première étape S1 est suivie d'une étape S2 de formation, entre les cellules photovoltaïques 2 du second réseau, des cellules photovoltaïques 1 du premier réseau.

Cette étape S2 peut s'effectuer de différentes manières. Il est possible de graver des évidements dans l'empilement de couches minces à l'étape S1 pour définir les cellules du second réseau, et délimiter par la même occasion des zones destinées à accueillir les cellules du premier réseau. Des cellules photovoltaïques à concentration 1 peuvent alors être agencées par dépôt dans ces évidements à l'étape S2.

Ces évidements peuvent être faits par gravure chimique à travers un masque, par attaque physique, bombardement ionique, ou par laser. Ce mode de réalisation peut par exemple inclure le cas où les évidements gravés dans l'empilement atteignent le substrat.

Les cellules photovoltaïques à concentration 1 peuvent être fabriquées directement dans les évidements séparant les cellules photovoltaïques 2 du second réseau. Une étape préalable consiste à déposer un matériau électriquement isolant 9 pour rendre électriquement indépendantes les cellules des deux réseaux. Il est en particulier possible de faire croître des couches minces en utilisant un matériau pour l'absorbeur des cellules du premier réseau différant du matériau utilisé dans l'absorbeur des cellules 2 du second réseau. La croissance des cellules à concentration peut se faire sur une couche métallique 4 formant un contact arrière commun aux cellules des deux réseaux. Elle peut aussi se faire en parallèle à la croissance des cellules du second réseau, à partir de contacts arrière 4 différenciés.

De manière avantageuse, les cellules photovoltaïques à concentration 1 sont réalisées dans les mêmes matériaux que les cellules photovoltaïques 2 du second réseau. En particulier, l'étape S2 peut simplement consister en une gravure, dans un empilement de couches minces, d'évidements délimitant simultanément le premier et le second réseau de cellules. Les évidements ainsi gravés ont avantageusement une largeur comprise entre 3 µm et 20 µm, et s'arrêtent à la couche tampon 6. Ces évidements peuvent donc n'être réalisés que dans la couche supérieure électriquement conductrice 7 pouvant par exemple être en ZnO, ZnO dopé aluminium, SnO₂, ou bien en ITO. Un matériau électriquement isolant 9 peut être déposé dans ces évidements et des contacts métalliques supérieurs 10, 20 sont disposés sélectivement pour, d'une part, connecter en surface la couche 7 formant contact avant des cellules à concentration 1, et, d'autre part, connecter en surface la couche 7 formant contact avant des cellules 2 du second réseau. Les contacts électriques reliant entre elles les cellules à concentration 1 d'une part, et les cellules 2 du second réseau d'autre part, sont ensuite réalisés.

Une étape S3 consiste à placer, au-dessus d'au moins une partie des cellules à concentration 1 du premier réseau, des systèmes de concentration de la lumière. Ces systèmes de concentration de la lumière peuvent par exemple être des lentilles 8, comme représenté sur la figure 1, ou bien des lentilles de Fresnel, ou encore des cônes à réflexion totale interne. Par contre, les systèmes de type miroir sont avantageusement exclus de ce procédé, dans la mesure où ils ne laissent pas pénétrer la lumière diffuse ou non alignée avec le système.

De nombreuses variantes de réalisation sont envisageables pour le procédé objet de l'invention ainsi que le dispositif qu'il permet d'obtenir.

En se référant à la figure 1, qui illustre un exemple de réalisation dans lequel les cellules à concentration 1 et les cellules dites « classiques » 2 du second réseau sont de forme sensiblement parallélépipédique, il est possible de décliner ce type de système photovoltaïque sous différentes géométries. La géométrie de la figure 1 est particulièrement propice à une utilisation faisant intervenir un système de suivi de la source lumineuse, communément appelé système de « tracking », à un axe. Il est alors possible de suivre la course du Soleil selon un axe est-ouest, de manière à rester, autant que faire se peut, dans des conditions d'illumination directe sur les cellules à concentration 1. Une géométrie alternative, par exemple en damier, circulaire, ou carrée est également possible, et peut avantageusement être associée à un système de « tracking » à deux axes. En l'absence de tout système de suivi de la source lumineuse, il est possible de réaliser des cellules photovoltaïques à concentration 1 possédant une géométrie qui épouse sensiblement la taille du spot lumineux généré par les lentilles lors du déplacement de la source lumineuse. Une telle optimisation de la forme géométrique des cellules serait particulièrement adaptée à des applications pour les toitures de maisons individuelles par exemple. Pour des immeubles ou toitures industrielles, un système de tracking est envisageable.

De manière avantageuse, une maille élémentaire du système photovoltaïque à concentration décrit ci-avant comprend une cellule photovoltaïque à concentration 1, deux portions d'isolant électrique 9 et une cellule 2 du second réseau. Une telle maille peut posséder une largeur typique de sensiblement 1 cm. L'isolant possède une largeur typique sensiblement comprise entre 500 nm et 20 µm comme décrit ci-avant. En fonction du type d'application visé, en particulier s'il comprend ou non un système de « tracking », le système optique de concentration peut présenter une concentration comprise entre 5 et 1000. Pour un système photovoltaïque à géométrie sensiblement parallélépipédique, comme celui illustré à la figure 1, ceci correspond à des rapports entre la largeur d'une lentille et la largeur d'une cellule à concentration compris entre 5 et 1000. Pour des lentilles de 1 cm de largeur en contact les unes avec les autres, de telles concentrations correspondraient à des largeurs de cellules à concentration comprises entre 2 mm et 10 µm. De manière avantageuse, la taille des cellules à concentration est choisie plus grande pour les applications dans des régions à ensoleillement faible, ou à fortes tendances nuageuses, et cette même taille est choisie plus petite pour les applications dans des régions à fort ensoleillement, et lorsque le système photovoltaïque est associé à un dispositif de « tracking ».

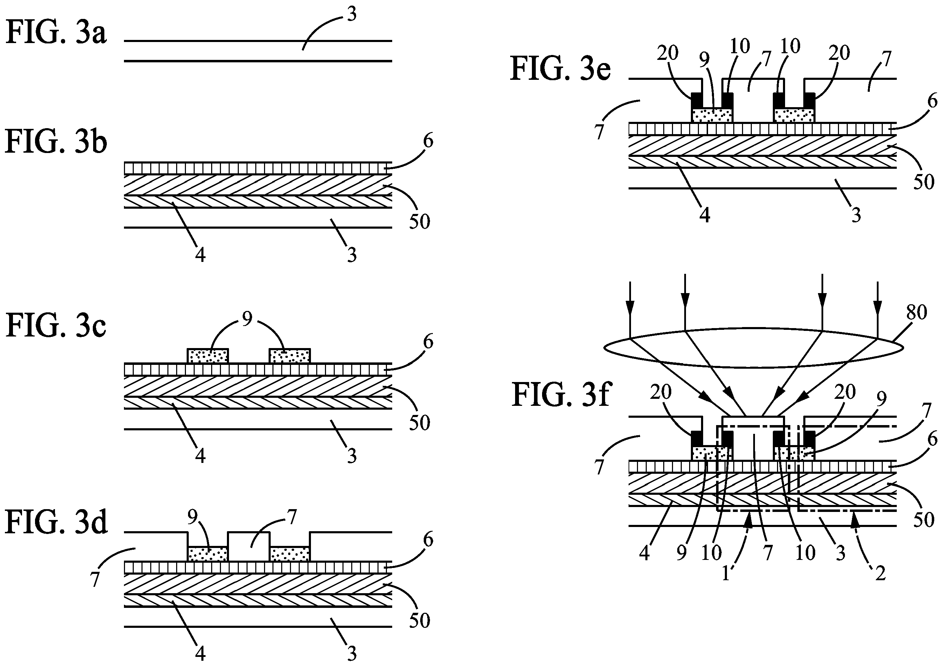

Les figures 3a à 3f illustrent schématiquement un système photovoltaïque à six étapes différentes d'un procédé de fabrication selon un mode de réalisation avantageux.

La figure 3a représente le substrat 3 sur lequel les cellules photovoltaïques sont fabriquées.

La figure 3b illustre un exemple d'empilement de couches minces avantageux pour réaliser le dispositif issu du procédé décrit. Cet empilement comprend, une couche métallique 4 formant contact arrière, avantageusement en molybdène. Au-dessus de ce contact arrière 4, il est possible de déposer une couche d'absorbeur 50, réalisée par exemple en un alliage du type Cu(In,Ga)Se₂, CZTS, tellurure de cadmium CdTe ou Silicium couche mince, pouvant être du silicium amorphe, silicium microcristallin, ou quasicristallin, ou autre variante déposée en couches minces. Par-dessus cet absorbeur 50, il est possible de déposer une couche tampon 6, par exemple en ZnS, CdS, ou In₂S₃. Finalement, le contact électrique supérieur peut être assuré par la présence d'une couche 7 électriquement conductrice en ZnO, ou bien un bicouche de ZnO et ZnO dopé aluminium, transparente dans les gammes de longueurs d'onde recherchées, entre l'UV et l'infrarouge. D'autres empilements de couches formant des cellules de type couches minces peuvent être utilisés.

Le mode de réalisation avantageux représenté sur les figures 3a à 3f comprend en outre une étape de dépôt d'une couche d'isolant pour y former des plots isolants 9, puis de contacts métalliques 10, 20, sur le bord de ces plots isolants. Une couche formant contact avant 7, avantageusement en ZnO, est ensuite déposée pour aboutir au dispositif représenté sur la figure 3c. Des évidements sont réalisés dans la couche formant contact avant 7. Ces évidements définissent des zones comprenant de larges portions de ZnO, délimitant ainsi les cellules photovoltaïques 2 du second réseau, et des zones comprenant des portions de ZnO plus petites, délimitant ainsi les cellules photovoltaïques à concentration 1 du premier réseau.

Comme illustré sur la figure 3d, la couche tampon 6 est recouverte d'un matériau 9 électriquement isolant. La présence de cette couche de matériau 9 électriquement isolant est avantageuse pour la formation ultérieure de contacts métalliques supérieurs différenciés pour les cellules à concentration 1 du premier réseau, et les cellules 2 du second réseau. La réalisation pratique d'un dépôt sélectif fait appel à des techniques connues de l'Homme du métier. Il est particulièrement avantageux de réaliser ces contacts métalliques sur les zones recouvertes par le matériau 9 électriquement isolant. En effet, ces zones n'étant pas destinées à être photosensibles, le dépôt de couches métalliques, réfléchissantes dans la gamme de longueurs d'onde désirée, sur ce matériau 9 électriquement isolant, ne réduit pas l'aire de la surface photosensible participant à la conversion d'énergie lumineuse en énergie électrique pour la zone 1, destinée à la concentration. La présence de ces contacts métalliques 10, 20, permet de limiter les pertes résistives qui peuvent autrement survenir dans la couche 7 formant le contact avant. Ces contacts peuvent également servir à réaliser la connexion des cellules photovoltaïques en série les unes aux autres.

Les contacts métalliques 10 sont situés de part et d'autre du contact avant 7, avantageusement en ZnO, recouvrant le dessus des cellules photovoltaïques à concentration 1. Les contacts métalliques 20 sont situés de part et d'autre du ZnO recouvrant le dessus des cellules photovoltaïques 2 du second réseau. Le contact entre le métal 10 et le contact avant 7 peut se faire tel que représenté sur les figures 3e et 3f. Alternativement, il est aussi possible de sélectivement déposer un excédent de ZnO sur le matériau 9 électriquement isolant avant l'étape de dépôt des contacts métalliques 10, 20, en s'assurant de maintenir une séparation entre le contact avant 7 des cellules à concentration 1 et le contact avant 7 des cellules photovoltaïques 2 du second réseau. Le dépôt des contacts métalliques 10, 20 peut alors se faire par-dessus cet excédent de ZnO. Quel que soit le mode de réalisation choisi, le contact avant 7 et les contacts métalliques 10, 20 sont en contact l'un avec l'autre. Il est particulièrement avantageux de maintenir le contact métallique 10, 20, à l'aplomb du matériau 9 électriquement isolant, afin de ne pas bloquer le rayonnement incident pouvant atteindre les cellules photosensibles.

La figure 3f représente le système photovoltaïque à concentration dans son intégralité, comprenant en outre des lentilles 80 alignées au-dessus d'au moins une partie des cellules photovoltaïques à concentration 1. L'alignement des lentilles 80 sur les cellules à concentration 1 fait appel à des techniques connues de l'Homme du métier.

Le dispositif représenté sur la figure 3f présente la particularité de ne différencier les cellules à concentration 1 et les cellules 2 du second réseau que par les contacts métalliques 10, 20 situés sur les faces supérieures des cellules photovoltaïques 1, 2, et les contacts supérieurs de la couche en ZnO 7. Les cellules des deux réseaux possèdent bien des connecteurs électriques indépendants, mais ils partagent néanmoins le même absorbeur 50, la même couche tampon 6, et le même contact arrière 4, ces couches ne présentant pas de discontinuités sur le panneau photovoltaïque. Le courant électrique circulant dans les cellules des deux réseaux ne peut pas transiter d'un réseau à l'autre via le contact arrière 4 ou l'absorbeur 50 en raison de la présence du matériau 9 électriquement isolant. En effet, la longueur de diffusion des porteurs dans un absorbeur de cellule photovoltaïque peut typiquement être inférieure à 3 µm. Cette longueur peut être comprise entre 100 nm et 3 µm, et est typiquement comprise entre 500 nm et 1 µm. Avec un isolant électrique 9 de 20 µm de large, les porteurs photogénérés dans l'absorbeur 50 ne peuvent pas transiter d'une cellule 1 du premier réseau vers une cellule 2 du second réseau. Ainsi, il devient possible de ne pas fabriquer des contacts arrière 4 différenciés pour les cellules des deux réseaux à partir du moment où leurs contacts supérieurs en ZnO sont différenciés ainsi que les contacts métalliques 10, 20.

Ce procédé est avantageux en ce qu'il permet de fabriquer rapidement et de manière économe les deux réseaux de cellules. En effet, les cellules à concentration 1 fabriquées dans le procédé décrit ci-avant et représenté sur les figures 3a à 3f sont faites dans le même empilement de couches que celui constituant les cellules photovoltaïques 2 du second réseau.

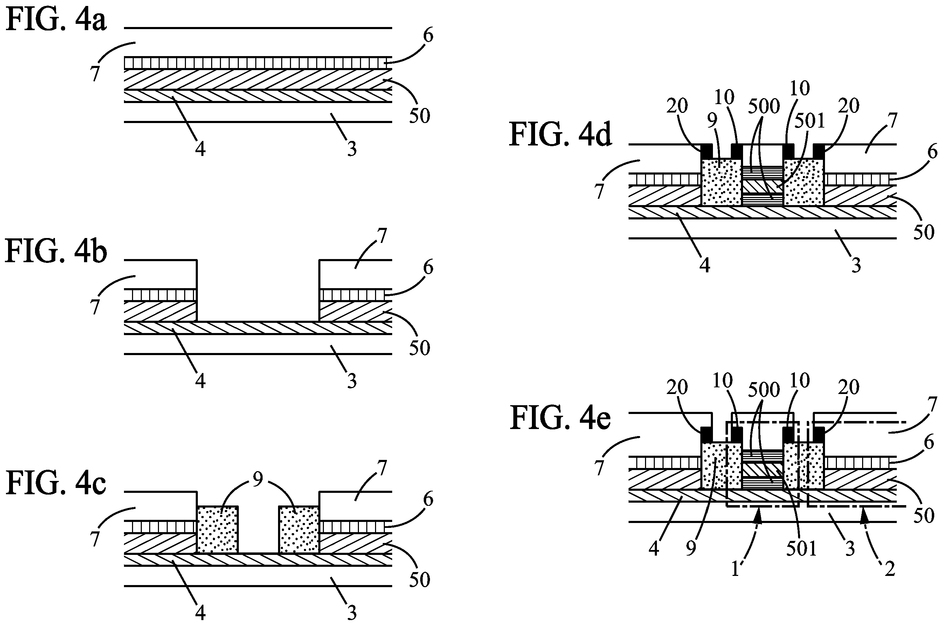

Les figures 4a à 4e représentent schématiquement un système photovoltaïque à quatre étapes différentes d'un procédé de fabrication selon un second mode de réalisation avantageux.

Il est d'abord procédé à la formation d'un empilement de couches minces, comme représenté sur la figure 4a. Il peut s'agir d'un empilement comprenant un contact arrière 4, un absorbeur 50, une couche tampon 6 et un contact supérieur en ZnO 7. D'autres variantes connues pour réaliser des panneaux photovoltaïques en couche minces peuvent être employées.

Une gravure éliminant un ensemble de couches jusqu'au contact arrière 4 est ensuite réalisée, pour aboutir à la structure représentée à la figure 4b. Cette gravure permet de délimiter les cellules photovoltaïques 2 du second réseau, séparées par des évidements de taille sensiblement supérieure à celle des futures cellules à concentration 1.

Un matériau 9 électriquement isolant est ensuite déposé dans les évidements créés. Il peut par exemple s'agir de polymères isolants comme la résine photosensible SU8 ou d'oxydes isolants tels que SiO₂, Al₂O₃. Des gravures sont avantageusement faites dans ce matériau 9 électriquement isolant de manière à ne laisser que sensiblement 20 µm d'isolant de part et d'autre des cellules photovoltaïques 2 du second réseau, comme illustré schématiquement à la figure 4c. Le matériau 9 électriquement isolant peut arriver à hauteur de la couche 7 formant contact électrique supérieur.

Les cellules photovoltaïques à concentration 1 peuvent ensuite être sélectivement déposées dans les évidements délimités par le matériau 9 électriquement isolant. Les cellules à concentration 1 peuvent être déposées par croissance in situ, en utilisant des techniques connues de l'Homme du métier pour fabriquer des cellules photovoltaïques. La figure 4d illustre le cas particulier dans lequel les cellules photovoltaïques à concentration 1 sont des cellules silicium à hétérojonction. Ces cellules 1 comprennent du silicium amorphe 500, du silicium cristallin 501, et un oxyde conducteur transparent, comme le ZnO 7.

Les contacts métalliques 10, 20, propres aux cellules à concentration 1 d'une part, et aux cellules 2 du second réseau d'autre part, peuvent être déposés sélectivement sur le matériau 9 électriquement isolant, comme décrit précédemment. Le système photovoltaïque ainsi obtenu est représenté schématiquement à la figure 4e.

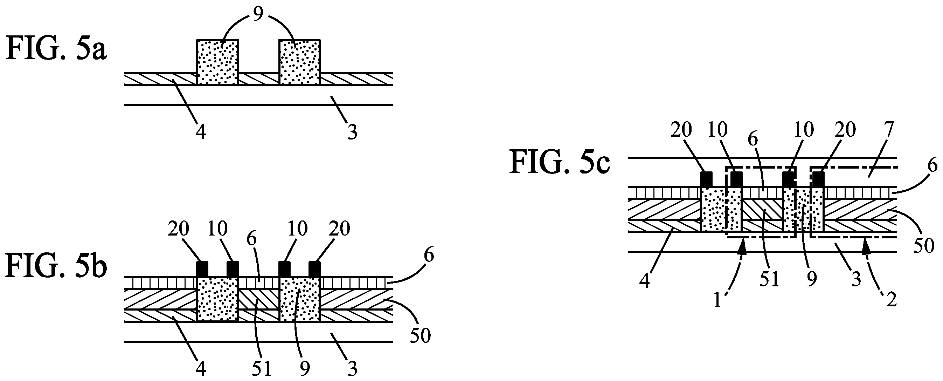

Les figures 5a à 5c représentent schématiquement un système photovoltaïque à trois étapes différentes d'un procédé de fabrication selon un troisième mode de réalisation avantageux.

Comme représenté sur la figure 5a, il est possible de déposer sélectivement une couche métallique 4 formant contact arrière sur des zones destinées à définir le premier réseau de cellules à concentration 1, et des zones destinées à définir le second réseau de cellules 2. Cette structuration peut se faire par dépôt puis gravure, ou bien en masquant les zones séparant les contacts arrière 4 à l'aide d'un matériau 9 électriquement isolant.

Les étapes suivantes consistent à déposer, par exemple en réalisant une croissance par des techniques bottom-up, des couches de matériaux comprises dans une cellule photovoltaïque. Comme illustré sur la figure 5b, ces couches peuvent comprendre un absorbeur 50, 51, qui peut par exemple être différent pour les couches des cellules à concentration 1, et les couches des cellules 2 du second réseau. Ces absorbeurs 50, 51 sont recouverts d'une couche tampon 6. Par ailleurs, des contacts métalliques 10, 20 peuvent être sélectivement déposés sur la face supérieure du matériau 9 électriquement isolant séparant les cellules à concentration 1 des cellules 2 du second réseau.

La couche supérieure en oxyde électriquement conducteur 7, par exemple en ZnO, peut être déposée par la suite. La figure 5c illustre le cas dans lequel les deux cellules possèdent un contact supérieur en Zn0 commun. Il est également possible que les deux types de cellules partagent plusieurs couches, parmi l'absorbeur 50, les couches tampon 6 et le contact avant 7, ces couches ne présentant alors pas de discontinuités sur le panneau photovoltaïque.

### Exemple de réalisation

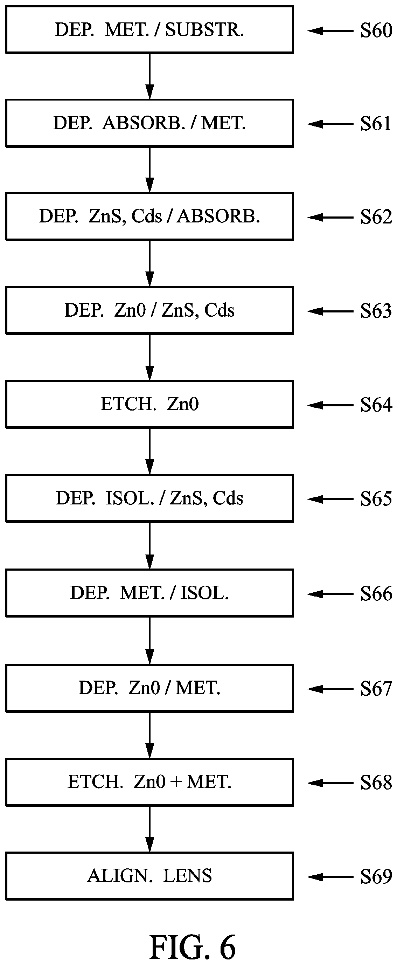

La figure 6 illustre de manière schématique les dix étapes d'un procédé de réalisation d'un système photovoltaïque à concentration de lumière apte à exploiter les composantes directes et diffuses de l'illumination.

Ce procédé comprend les premières étapes S60 à S63 de dépôt successif :
- d'une couche métallique 4 en molybdène formant contact arrière sur un substrat 3, à l'étape S60,
- d'un absorbeur 50, comme du Cu(In,Ga)Se₂, apte à absorber des photons pour générer des électrons conducteurs de courant, sur le contact arrière 4, à l'étape S61,
- d'une couche tampon 6, avantageusement en ZnS, CdS sur l'absorbeur 50, à l'étape S62, et
- d'une couche d'oxyde électriquement conducteur 7 de ZnO sur la couche tampon à l'étape S63.

L'étape S64 consiste en la gravure d'évidements, de largeur comprise entre 50 µm et 2 mm, dans la couche d'oxyde électriquement conducteur 7 de ZnO.

Dans ces évidements, un matériau 9 électriquement isolant comme par exemple la silice, est déposé, à l'étape S65. L'isolant 9 repose donc sur la couche tampon 6.

À l'étape S66, du métal est déposé sur le matériau 9 électriquement isolant, pour permettre de réduire les pertes résistives dans les cellules et pour pouvoir relier en série ou parallèle les cellules à concentration 1 entre elles. De la même manière ces contacts métalliques permettent de relier les cellules 2 du second réseau entre elles en série ou parallèle.

L'étape S67 qui suit consiste à déposer du ZnO par-dessus le métal précédemment déposé sur le matériau 9 électriquement isolant.

Il est ensuite procédé à une gravure du ZnO et du métal, au-dessus du matériau isolant, à l'étape S68. Cette gravure permet de différencier les contacts métalliques 10 des cellules à concentration 1 des contacts métalliques 20 des cellules 2 du second réseau. Cette gravure s'effectue jusqu'à atteindre le matériau 9 électriquement isolant.

À l'étape S69, des lentilles 8 formant le système optique de concentration de la lumière sont alignées au-dessus d'au moins une partie des cellules à concentration 1.

Outre les différents modes de réalisation décrits ci-avant, l'invention peut comprendre des modes de réalisation alternatifs équivalents.

Par exemple, la formation d'évidements dans les matériaux constituant le panneau photosensible peut être réalisée avec une profondeur variable. En effet, cette gravure peut s'arrêter sous la couche électriquement conductrice formant un contact électrique avant 7. La gravure peut également traverser des matériaux situés sous ce contact électrique, et peut même atteindre et pénétrer le contact arrière 4.

L'ordre des étapes décrites ci-avant peut également présenter certaines variantes. Par exemple, il est possible de déposer le matériau électriquement isolant 9 à toute étape du procédé après la réalisation d'évidements, dans les modes de réalisation prévoyant la formation de ces évidements. Les contacts métalliques 10, 20, peuvent alors être déposés sélectivement sur ce matériau électriquement isolant 9 avant ou après le dépôt de la couche formant contact avant 7 pouvant être en ZnO.

## Revendications

1. Procédé de fabrication d'un dispositif photovoltaïque à concentration de lumière, comprenant :
- une première étape (S2) de fabrication, sur un substrat (3), d'un premier réseau de cellules photovoltaïques (1) à partir d'un empilement de couches déposé sur ledit substrat (3), les cellules du premier réseau étant reliées à un premier groupe de connecteurs électriques,
- une deuxième étape (S3) de formation d'un système de concentration de lumière (8, 80) au-dessus des cellules (1) dudit premier réseau,
- une troisième étape (S1), préalable à la deuxième étape (S3) au moins, de formation, sur ledit substrat (3), d'un second réseau de cellules photovoltaïques (2) à partir d'un empilement de couches déposé sur ledit substrat (3), les cellules du second réseau étant intercalées avec les cellules (1) du premier réseau et reliées à un second groupe de connecteurs électriques, et étant dépourvues de système de concentration de lumière,
le procédé étant **caractérisé en ce que** les empilements respectifs de la première étape et de la troisième étape comportent au moins une couche commune

2. Procédé selon la revendication 1, **caractérisé en ce que** les empilements respectifs de la première étape et de la troisième étape sont identiques.

3. Procédé selon l'une des revendications précédentes, **caractérisé en ce que** les cellules (1) du premier réseau sont agencées dans des évidements réalisés dans au moins une partie des matériaux formant les cellules (2) du second réseau.

4. Procédé selon l'une des revendications 1 à 2, **caractérisé en ce qu'**il comprend les étapes successives suivantes :
- la formation, sur le substrat (3), d'un empilement de couches minces,
- la gravure, dans l'empilement de couches minces, d'évidements définissant le premier et le second réseau de cellules photovoltaïques,
- le dépôt, dans lesdits évidements, d'un matériau électriquement isolant (9),
- le dépôt, sur une partie du matériau électriquement isolant (9) adjacente aux cellules (1) du premier réseau, des contacts métalliques (10) du premier réseau de cellules photovoltaïques (1).

5. Procédé selon la revendication 3, **caractérisé en ce qu'**il comprend, les étapes successives suivantes :
- la formation, sur le substrat (3), d'un empilement de couches minces,
- la gravure, dans l'empilement de couches minces, d'évidements délimitant le second réseau de cellules photovoltaïques,
- le dépôt, dans une partie des évidements créés, de cellules à concentration (1) formant le premier réseau de cellules photovoltaïques.

6. Procédé selon l'une des revendications 1 à 2, **caractérisé en ce qu'**il comprend les étapes successives suivantes :
- le dépôt, sur le substrat (3), d'une couche métallique formant contact arrière (4),
- la gravure, dans ladite couche métallique (4), d'évidements délimitant les contacts arrière du premier et du second réseau de cellules photovoltaïques (1, 2),
- le dépôt, sur lesdits contacts arrière (4), des cellules photovoltaïques (1, 2) du premier et du second réseau.

7. Procédé selon la revendication 6, **caractérisé en ce qu'**il comprend les étapes successives suivantes :
- le dépôt, sur le substrat (3), d'un masque délimitant deux réseaux de zones exposées intercalées,
- le dépôt, sur ledit substrat (3), d'un métal formant deux réseaux de contacts arrière (4) intercalés,
- le dépôt, sur lesdits contacts arrière (4), des cellules photovoltaïques (1, 2) du premier et du second réseau.

8. Système photovoltaïque à concentration de lumière comprenant sur un substrat (3):
- un premier réseau de cellules photovoltaïques (1) en empilement de couches déposé sur ledit substrat, les cellules du premier réseau étant reliées à un premier groupe de connecteurs électriques, et
- un système de concentration de la lumière (8, 80), ledit système étant agencé au-dessus des cellules (1) dudit premier réseau,un second réseau de cellules photovoltaïques (2) en empilement de couches déposé sur ledit substrat, les cellules du second réseau étant intercalées avec les cellules du premier réseau et reliées à un second groupe de connecteurs électriques, et étant dépourvues de système de concentration de lumière ;
le système étant **caractérisé en ce que** les empilements des premier (1) et second (2) réseaux comportent au moins une couche commune.

9. Système photovoltaïque selon la revendication 8, **caractérisé en ce que** lesdits empilements sont identiques.

10. Système photovoltaïque selon l'une quelconque des revendications 8 ou 9, **caractérisé en ce que** les cellules photovoltaïques (1) du premier réseau sont séparées des cellules photovoltaïques (2) du second réseau par un matériau électriquement isolant (9).

11. Système photovoltaïque selon la revendication 10, **caractérisé en ce que** le matériau électriquement isolant (9) sépare les cellules (1) du premier réseau des cellules (2) du second réseau d'une distance comprise entre 10 µm et 100 µm, avantageusement 20 µm.

12. Système photovoltaïque selon l'une quelconque des revendications 8, 10 ou 11, **caractérisé en ce que** les cellules photovoltaïques (1) du premier réseau comprennent une couche (51, 500, 501) à propriétés photovoltaïques réalisée dans un matériau différent d'une couche (50) à propriétés photovoltaïques que comportent les cellules (2) photovoltaïques du second réseau.

13. Système photovoltaïque selon l'une quelconque des revendications 8 à 10, **caractérisé en ce qu'**il est associé à un dispositif de suivi de la source du rayonnement incident.

## Patentansprüche

1. Verfahren zur Herstellung einer photovoltaischen Lichtkonzentrationsvorrichtung, umfassend:
- einen ersten Schritt (S2) der Herstellung, auf einem Substrat (3), eines ersten Netzes von Photovoltaikzellen (1) aus einem Stapel von Schichten, der auf das Substrat (3) aufgebracht ist, wobei die Zellen des ersten Netzes mit einer ersten Gruppe von elektrischen Anschlüssen verbunden sind,
- einen zweiten Schritt (S3) der Bildung eines Lichtkonzentrationssystems (8, 80) über den Zellen (1) des ersten Netzes,
- einen dritten Schritt (S1) mindestens vor dem zweiten Schritt (S3) der Bildung, auf dem Substrat (3) eines zweiten Netzes von Photovoltaikzellen (2) aus einem Stapel von Schichten, der auf das Substrat (3) aufgebracht ist, wobei die Zellen des zweiten Netzes zwischen die Zellen (1) des ersten Netzes zwischengefügt und mit einer zweiten Gruppe von elektrischen Anschlüssen verbunden sind und kein Lichtkonzentrationssystem besitzen,
wobei das Verfahren **dadurch gekennzeichnet ist, dass** die jeweiligen Stapel des ersten Schritts und des dritten Schritts mindestens eine gemeinsame Schicht umfassen.

2. Verfahren nach Anspruch 1, **dadurch gekennzeichnet, dass** die jeweiligen Stapel des ersten Schritts und des dritten Schritts identisch sind.

3. Verfahren nach einem der vorhergehenden Ansprüche, **dadurch gekennzeichnet, dass** die Zellen (1) des ersten Netzes in Aussparungen angeordnet sind, die in mindestens einem Teil der Materialien, die die Zellen (2) des zweiten Netzes bilden, vorgesehen sind.

4. Verfahren nach einem der Ansprüche 1 bis 2, **dadurch gekennzeichnet, dass** es die folgenden Schritte hintereinander umfasst:
- die Bildung eines Stapels von dünnen Schichten auf dem Substrat (3),
- das Eingravieren von Aussparungen, die das erste und das zweite Netz von Photovoltaikzellen definieren, in den Stapel von dünnen Schichten,
- das Aufbringen eines elektrisch isolierenden Materials (9) in die Aussparungen,
- das Aufbringen der metallischen Kontakte (10) des ersten Netzes von Photovoltaikzellen (1) auf einen Teil des elektrisch isolierenden Materials (9), der an die Zellen (1) des ersten Netzes angrenzt.

5. Verfahren nach Anspruch 3, **dadurch gekennzeichnet, dass** es die folgenden Schritte hintereinander umfasst:
- die Bildung eines Stapels von dünnen Schichten auf dem Substrat (3),
- das Eingravieren von Aussparungen, die das zweite Netz von Photovoltaikzellen begrenzen, in den Stapel von dünnen Schichten,
- das Aufbringen von Konzentrationszellen (1), die das erste Netz von Photovoltaikzellen bilden, in einen Teil der erzeugten Aussparungen.

6. Verfahren nach einem der Ansprüche 1 bis 2, **dadurch gekennzeichnet, dass** es die folgenden Schritte hintereinander umfasst:
- das Aufbringen einer metallischen Schicht, die einen hinteren Kontakt (4) bildet, auf das Substrat (3),
- das Eingravieren von Aussparungen, die die hinteren Kontakte des ersten und des zweiten Netzes von Photovoltaikzellen (1, 2) begrenzen, in die metallische Schicht (4),
- das Aufbringen der Photovoltaikzellen (1, 2) des ersten und des zweiten Netzes auf die hinteren Kontakte (4).

7. Verfahren nach Anspruch 6, **dadurch gekennzeichnet, dass** es die folgenden Schritte hintereinander umfasst:
- das Aufbringen einer Maske, die zwei Netze von zwischen einander gefügten exponierten Zonen begrenzt, auf das Substrat (3),
- das Aufbringen eines Metalls, das zwei Netze von zwischen einander gefügten hinteren Kontakten (4) bildet, auf das Substrat (3),
- das Aufbringen der Photovoltaikzellen (1, 2) des ersten und des zweiten Netzes auf die hinteren Kontakte (4).

8. Photovoltaisches Lichtkonzentrationssystem, umfassend auf einem Substrat (3):
- ein erstes Netz von Photovoltaikzellen (1) in einem Stapel von Schichten, der auf das Substrat aufgebracht ist, wobei die Zellen des ersten Netzes mit einer ersten Gruppe von elektrischen Anschlüssen verbunden sind, und
- ein Lichtkonzentrationssystem (8, 80), wobei das System über den Zellen (1) des ersten Netzes angeordnet ist, ein zweites Netz von Photovoltaikzellen (2) in einem Stapel von Schichten, der auf das Substrat aufgebracht ist, wobei die Zellen des zweiten Netzes zwischen die Zellen des ersten Netzes zwischengefügt und mit einer zweiten Gruppe von elektrischen Anschlüssen verbunden sind und kein Lichtkonzentrationssystem besitzen;
wobei das System **dadurch gekennzeichnet ist, dass** die Stapel der ersten (1) und zweiten Netze (2) mindestens eine gemeinsame Schicht umfassen.

9. Photovoltaiksystem nach Anspruch 8, **dadurch gekennzeichnet, dass** die Stapel identisch sind.

10. Photovoltaiksystem nach einem der Ansprüche 8 oder 9, **dadurch gekennzeichnet, dass** die Photovoltaikzellen (1) des ersten Netzes von den Photovoltaikzellen (2) des zweiten Netzes durch ein elektrisch isolierendes Material (9) getrennt sind.

11. Photovoltaiksystem nach Anspruch 10, **dadurch gekennzeichnet, dass** das elektrisch isolierende Material (9) die Zellen (1) des ersten Netzes von den Zellen (2) des zweiten Netzes um einen Abstand zwischen 10 µm und 100 µm, vorteilhafterweise von 20 µm, trennt.

12. Photovoltaiksystem nach einem der Ansprüche 8, 10 oder 11, **dadurch gekennzeichnet, dass** die Photovoltaikzellen (1) des ersten Netzes eine Schicht (51, 500, 501) mit photovoltaischen Eigenschaften umfassen, die aus einem anderen Material als eine Schicht (50) mit photovoltaischen Eigenschaften, die die Photovoltaikzellen (2) des zweiten Netzes umfassen, hergestellt ist.

13. Photovoltaiksystem nach einem der Ansprüche 8 bis 10, **dadurch gekennzeichnet, dass** sie einer Vorrichtung zur Kontrolle der Quelle der eintreffenden Strahlung zugeordnet ist.

## Claims

1. A method for fabricating a photovoltaic device with light concentration, comprising:
a first step (S2) of fabricating, on a substrate (3), a first array of photovoltaic cells (1) from a stack of layers deposited on said substrate (3), the cells of the first array being connected to a first group of electrical connectors,
a second step (S3) of forming a light concentration system (8, 80) over the cells (1) of said first array,
a third step (S1), prior to at least the second step (S3), of forming, on said substrate (3) a second array of photovoltaic cells (2) from a stack of layers deposited on said substrate (3), the cells of the second array being interspersed among the cells (1) of the first array and connected to a second group of electrical connectors and being without a light concentration system,
the method being **characterized in that** respective stacks obtained by fabricating the first array of photovoltaic cells and by forming the second array of photovoltaic cells comprise at least one common layer.

2. Method according to claim 1, wherein the respective stacks are identical.

3. Method according to any of the preceding claims, wherein the cells (1) of the first array are arranged in recesses created in at least a part of the materials forming the cells (2) of the second array.

4. Method according to any of claims 1 to 2, wherein it further comprises:
forming a stack of thin films on the substrate (3),
etching recesses in the stack of thin films, to delimit the first and second array of photovoltaic cells,
depositing an electrically insulating material (9) in said recesses, depositing, on a portion of electrically insulating material (9) adjacent to the cells (1) of the first array, metal contacts (10) for the first array of photovoltaic cells (1).

5. Method according to claim 3, wherein it further comprises:
forming a stack of thin films on the substrate (3),
etching recesses in the stack of thin films, to delimit the second array of photovoltaic cells,
depositing, on a portion of the recesses created, concentration cells (1) forming the first array of photovoltaic cells.

6. Method according to claims 1 to 2, wherein it comprises the following successive steps of:
depositing, on the substrate (3), a metal layer forming a rear contact (4),
etching recesses in said metal layer (4), to delimit the rear contacts of the first and second array of photovoltaic cells (1, 2),
depositing, on said rear contacts (4), the photovoltaic cells (1, 2) of the first and second array.

7. Method according to claim 6, wherein it comprises the following successive steps of:
depositing, on the substrate (3), a mask delimiting two arrays of interspersed exposed areas,
depositing, on said substrate (3), a metal layer forming two arrays of interspersed rear contacts (4),
depositing, on said rear contacts (4), the photovoltaic cells (1, 2) of the first and second array.

8. Photovoltaic system with light concentration, comprising on a substrate (3):
a first array of photovoltaic cells (1) in a stack of layers deposited on said substrate, the cells of the first array being connected to a first group of electrical connectors,
a light concentration system (8, 80), said system being arranged above the cells (1) of said first array, and
a second array of photovoltaic cells (2) in a stack of layers deposited on said substrate, the cells of the second array being interspersed with the cells of the first array and connected to a second group of electrical connectors, and being without any light concentration system,
the system being **characterized in that** the stacks of the first and second arrays comprise at least one common layer.

9. Photovoltaic system according to claim 8, wherein said stacks are identical.

10. Photovoltaic system according to any of claims 8 or 9, wherein the photovoltaic cells (1) of the first array are separated from the photovoltaic cells (2) of the second array by an electrically insulating material (9).

11. Photovoltaic system according to claim 10, wherein the electrically insulating material (9) separates the cells (1) of the first array from the cells (2) of the second array by a distance of between 10 µm and 100 µm, preferably 20 µm.

12. Photovoltaic system according to any of claims 8, 10 or 11, wherein the photovoltaic cells (1) of the first array comprise a layer (51, 500, 501) with photovoltaic properties made of a different material than a layer (50) with photovoltaic properties comprised in the photovoltaic cells (2) of the second array.

13. Photovoltaic system according to any of claims 8 to 10, wherein it is associated with a device for tracking the source of the incident radiation.
